# EUROPEAN PATENT APPLICATION

(11) **EP 4 610 695 A1**
(43) Date of publication of application: **03.09.2025**
(21) Application number: 22965569.1
(22) Date of filing: 18.11.2022
(51) Int. Cl.: G01S 17/00

(54) **INTEGRATED APPARATUS, DETECTION APPARATUS, TERMINAL AND MANUFACTURING METHOD**

(71) Applicant: Shenzhen Yinwang Intelligent Technologies Co., Ltd., Shenzhen, Guangdong 518129 (CN)
(72) Inventor: WANG, Shuai, Shenzhen, Guangdong 518129 (CN); CHEN, Meng, Shenzhen, Guangdong 518129 (CN); LI, Zhaoyong, Shenzhen, Guangdong 518129 (CN); WEI, Jiangbo, Shenzhen, Guangdong 518129 (CN); HOU, Hongjiang, Shenzhen, Guangdong 518129 (CN)
(74) Representative: Pfenning, Meinig & Partner mbB
(86) International application number: PCT/CN2022/132858
(87) International publication number: WO 2024/103388

(57) **Abstract**

An integrated apparatus, a detection apparatus, a terminal, and a manufacturing method are disclosed, relate to the field of electronic technologies, and are used to resolve problems of heat dissipation and proneness to a chip stress of a sensing chip. The integrated apparatus includes a substrate layer, a sensing chip, and a PCB. The sensing chip is disposed on the substrate layer. The PCB is disposed on the substrate layer, the PCB is provided with an opening, the sensing chip is located in the opening, and the sensing chip is connected to the PCB through a transmission line. A difference between a coefficient of thermal expansion CTE of the substrate layer and a CTE of the sensing chip is less than a first preset threshold. In this way, the sensing chip can rapidly dissipate heat by using the substrate layer, and under a same temperature difference, it can be ensured that a deformation amount of the substrate layer is basically consistent with a deformation amount of the sensing chip, thereby resolving the problem of the chip stress of the sensing chip.

## Description

### TECHNICAL FIELD

This application relates to the field of electronic technologies, and in particular, to an integrated apparatus, a detection apparatus, a terminal, and a manufacturing method.

### BACKGROUND

A lidar (light detection and ranging, LiDAR) is an optical measurement device whose working principle is to emit a laser signal to an object, receive a target echo signal reflected by the object, and compare the target echo signal with the laser signal to obtain related parameters such as a location and a distance of the object. The lidar can accurately scan a surrounding object to form a high-definition image, helping implement quick recognition and decision-making for the surrounding object. Currently, the lidar is widely used in scenarios such as intelligent vehicles, smart transportation, urban three-dimensional mapping, and atmospheric environment monitoring.

Currently, with continuous improvement of object recognition precision of the lidar and continuous iterative update of a cable harness and an angular resolution of the lidar, requirements on signal processing speed performance of a receiving module in the lidar and a target surface of a photosensitive chip are continuously raised. Consequently, power consumption of the receiving module is multiplied. Therefore, a heat dissipation problem caused by an increase in the power consumption of the receiving module needs to be urgently resolved.

### SUMMARY

This application provides an integrated apparatus, a detection apparatus, a terminal, and a manufacturing method, to resolve problems of heat dissipation and proneness to a chip stress of a sensing chip.

According to a first aspect, this application provides an integrated apparatus. The integrated apparatus includes a substrate layer, a sensing chip, and a printed circuit board PCB. The substrate layer may include a material with good heat dissipation performance, for example, a metal material and/or a ceramic material. The sensing chip may be a chip integrated with a sensor. The sensing chip is disposed on the substrate layer, so that the sensing chip can quickly dissipate heat by using the substrate layer. The PCB is disposed on the substrate layer, the PCB is provided with an opening, the sensing chip is located in the opening, and the sensing chip is connected to the PCB through a transmission line. A difference between a coefficient of thermal expansion CTE of the substrate layer and a CTE of the sensing chip is less than a first preset threshold, that is, a difference obtained by subtracting the CTE of the sensing chip from the CTE of the substrate layer is less than the first preset threshold, or a difference obtained by subtracting the CTE of the substrate layer from the CTE of the sensing chip is less than the first preset threshold. Therefore, the difference between the CTE of the substrate layer and the CTE of the sensing chip is small.

In the foregoing technical solution, the sensing chip and the PCB are disposed on the substrate layer, the sensing chip is located in the opening on the PCB, the sensing chip is connected to the PCB through the transmission line, and the difference between the CTE of the substrate layer and the CTE of the sensing chip is less than the first preset threshold. In this way, the sensing chip can rapidly dissipate heat by using the substrate layer, and under a same temperature difference, it can be ensured that a deformation amount of the substrate layer is basically consistent with a deformation amount of the sensing chip, thereby resolving a problem of a chip stress of the sensing chip.

In a possible implementation of the first aspect, the substrate layer includes a base layer and a boss, the sensing chip is disposed on the boss, and the boss may also be located in the opening on the PCB, that is, both the boss and the sensing chip are located in the opening on the PCB. The sensing chip may further pass through the opening on the PCB. In the foregoing possible implementation, the sensing chip is disposed on the boss of the substrate layer, so that heat dissipation performance of the sensing chip can be further improved.

In a possible implementation of the first aspect, the base layer and the boss are integrally formed, that is, the base layer and the boss may be two parts of a same substrate layer that are formed in one process. In this way, a process of forming the substrate layer can be simplified. Alternatively, the base layer and the boss are not integrally formed, but are two parts that are independently disposed. For example, the base layer and the boss may be formed in two independent processes. When the base layer and the boss are two independently disposed parts, the boss may be bonded to the base layer through an adhesive, or may be riveted to the base layer through a rivet or the like. In this way, flexibility and diversity of forming the base layer and the boss can be improved.

In a possible implementation of the first aspect, a material of the base layer is the same as or different from a material of the boss. In a possible example, the material of the base layer is the same as the material of the boss. For example, both the material of the base layer and the material of the boss are aluminum silicon carbide AlSiC, copper Cu, aluminum Al, or wolfram W. In another possible example, the material of the base layer is different from the material of the boss. For example, the material of the base layer is aluminum Al, copper Cu, or wolfram W, and the material of the boss is aluminum silicon carbide AlSiC.

In a possible implementation of the first aspect, the sensing chip is bonded to the substrate layer through an adhesive. For example, the adhesive may be a glass adhesive, a single-component adhesive, or a multi-component adhesive. Alternatively, the sensing chip is soldered or riveted to the substrate layer. In the foregoing possible implementation, diversity and flexibility of a connection between the sensing chip and the substrate layer can be improved.

In a possible implementation of the first aspect, the first preset threshold is greater than or equal to 0 ppm/°C and less than or equal to 10 ppm/°C. In an example, the CTE of the sensing chip 220 may be about 2 ppm/°C, and the CTE of the substrate layer 210 may be greater than or equal to 3 ppm/°C and less than or equal to 12 ppm/°C. In the foregoing possible implementation, the sensing chip can quickly dissipate heat by using the substrate layer, and under a same temperature difference, it can be ensured that a deformation amount of the substrate layer is basically consistent with a deformation amount of the sensing chip, thereby resolving a problem of a chip stress of the sensing chip
In a possible implementation of the first aspect, the substrate layer includes at least one of the following materials: aluminum silicon carbide AlSiC, aluminum Al, copper Cu, and wolfram W. In the foregoing possible implementation, flexibility and diversity of forming the substrate layer are improved, and heat dissipation performance of the sensing chip disposed on the substrate layer can be ensured.

In a possible implementation of the first aspect, there is a height difference between the sensing chip and the PCB. For example, a height of the sensing chip is greater than a height of the PCB; or a height of the sensing chip is less than a height of the PCB. In the foregoing possible implementation, when there is the height difference between the sensing chip and the PCB, it is helpful to form the transmission line between the sensing chip and the PCB when the integrated apparatus is manufactured.

In a possible implementation of the first aspect, the integrated apparatus further includes a lens structure. The lens structure covers the sensing chip and is fastened to the substrate layer, where a focus of the lens structure is located on a photosensitive surface of the sensing chip. In the foregoing possible implementation, the integrated apparatus may be a receiving module, and can ensure that the sensing chip receives an optical signal focused by the lens structure.

In a possible implementation of the first aspect, a difference between a CTE of the lens structure and the CTE of the sensing chip is less than a second preset threshold, that is, a difference obtained by subtracting the CTE of the sensing chip from the CTE of the lens structure is less than the second preset threshold, or a difference obtained by subtracting the CTE of the lens structure from the CTE of the sensing chip is less than the second preset threshold. Optionally, the second preset threshold is greater than or equal to 0 ppm/°C and less than or equal to 10 ppm/°C. In this way, under a same temperature difference, it can be ensured that a deformation amount of the lens structure is basically consistent with a deformation amount of the sensing chip, so that the focus of the lens structure is always located on the photosensitive surface of the sensing chip. This avoids a decrease in an MTF of the sensing chip at a high temperature and a low temperature due to inconsistency between the deformation amount of the lens structure and the deformation amount of the sensing chip.

In a possible implementation of the first aspect, the integrated apparatus further includes a protective adhesive for protecting the transmission line. That is, when the integrated circuit is manufactured, the transmission line may be further coated with the protective adhesive, to avoid interference caused by a peripheral component of the transmission line to a transmission signal on the transmission line. Optionally, the protective adhesive may be a glass adhesive.

In a possible implementation of the first aspect, the integrated apparatus further includes protective glass, and the protective glass is located above the sensing chip. In the foregoing possible implementation, the protective glass is disposed above the sensing chip, so that dust, sundries, or the like cannot fall on the sensing chip, so as to avoid impact on performance of the sensing chip.

In a possible implementation of the first aspect, the PCB is bonded to the substrate layer through an adhesive. For example, the adhesive may be a glass adhesive, a single-component adhesive, or a multi-component adhesive. Alternatively, the PCB is soldered or riveted to the substrate layer. In the foregoing possible implementation, diversity and flexibility of a connection between the PCB and the substrate layer can be improved.

In a possible implementation of the first aspect, the sensing chip is a die, the die may also be referred to as a die or a bare die, and the die or the bare die may be a small block obtained by cutting from a wafer. Optionally, the sensing chip is a photosensitive chip. In an example, the photosensitive chip is a SPAD chip. In this way, when the integrated apparatus is used in a receiving module of a lidar, heat dissipation performance of the photosensitive chip in the receiving module can be improved, and a problem of a chip stress occurring on the sensing chip due to inconsistency between the CTE of the sensing chip and the CTE of the PCB is avoided.

According to a second aspect, a detection apparatus is provided, where the detection apparatus includes a control circuit and the integrated apparatus provided in the first aspect or any one of the possible implementations of the first aspect, and the control circuit is configured to receive a signal output by the integrated apparatus.

According to a third aspect, a terminal is provided, where the terminal includes the detection apparatus provided in the second aspect, and optionally, the terminal is a vehicle.

According to a fourth aspect, a manufacturing method for an integrated apparatus is provided, where the integrated apparatus includes a substrate layer, a sensing chip, and a PCB having an opening, and the method includes: forming the substrate layer, where the substrate layer may include a material with good heat dissipation performance, for example, a metal material and/or a ceramic material; disposing the sensing chip on the substrate layer, where the sensing chip may be a chip integrated with a sensor; and disposing the PCB on the substrate layer, and connecting the sensing chip to the PCB through a transmission line, where the sensing chip is located in the opening of the PCB. A difference between a coefficient of thermal expansion CTE of the substrate layer and a CTE of the sensing chip is less than a first preset threshold, that is, a difference obtained by subtracting the CTE of the sensing chip from the CTE of the substrate layer is less than the first preset threshold, or a difference obtained by subtracting the CTE of the substrate layer from the CTE of the sensing chip is less than the first preset threshold. Therefore, the difference between the CTE of the substrate layer and the CTE of the sensing chip is small.

In a possible implementation of the fourth aspect, the substrate layer includes a base layer and a boss, the sensing chip is disposed on the boss, and the boss may also be located in the opening on the PCB, that is, both the boss and the sensing chip are located in the opening on the PCB. The sensing chip may further pass through the opening on the PCB.

In a possible implementation of the fourth aspect, the base layer and the boss are integrally formed, that is, the base layer and the boss may be two parts of a same substrate layer that are formed in one process. In this way, a process of forming the substrate layer can be simplified. Alternatively, the base layer and the boss are not integrally formed, but are two parts that are independently disposed. For example, the base layer and the boss may be formed in two independent processes.

In a possible implementation of the fourth aspect, a material of the base layer is the same as a material of the boss. Alternatively, a material of the base layer is different from a material of the boss.

In a possible implementation of the fourth aspect, the disposing the sensing chip on the substrate layer includes: bonding the sensing chip to the substrate layer through an adhesive, where for example, the adhesive may be a glass adhesive, a single-component adhesive, or a multi-component adhesive; or soldering or riveting the sensing chip to the substrate layer.

In a possible implementation of the fourth aspect, the first preset threshold is greater than or equal to 0 ppm/°C and less than or equal to 10 ppm/°C. In an example, the CTE of the sensing chip 220 may be about 2 ppm/°C, and the CTE of the substrate layer 210 may be greater than or equal to 3 ppm/°C and less than or equal to 12 ppm/°C.

In a possible implementation of the fourth aspect, the substrate layer includes at least one of the following materials: aluminum silicon carbide AlSiC, aluminum Al, copper Cu, and wolfram W.

In a possible implementation of the fourth aspect, there is a height difference between the sensing chip and the PCB. For example, a height of the sensing chip is greater than a height of the PCB; or a height of the sensing chip is less than a height of the PCB.

In a possible implementation of the fourth aspect, the integrated apparatus further includes a lens structure, and the method further includes: covering the sensing chip with the lens structure and fastening the lens structure to the substrate layer, where a focus of the lens structure is located on a photosensitive surface of the sensing chip.

In a possible implementation of the fourth aspect, a difference between a CTE of the lens structure and the CTE of the sensing chip is less than a second preset threshold. In other words, a difference obtained by subtracting the CTE of the sensing chip from the CTE of the lens structure is less than the second preset threshold, or a difference obtained by subtracting the CTE of the lens structure from the CTE of the sensing chip is less than the second preset threshold.

In a possible implementation of the fourth aspect, the second preset threshold is greater than or equal to 0 ppm/°C and less than or equal to 10 ppm/°C.

In a possible implementation of the fourth aspect, the integrated apparatus further includes a protective adhesive, and the method further includes: disposing the protective adhesive on the transmission line, to avoid interference caused by a peripheral component of the transmission line to a transmission signal on the transmission line. Optionally, the protective adhesive may be a glass adhesive.

In a possible implementation of the fourth aspect, the integrated apparatus further includes protective glass, and the method further includes: disposing the protective glass above the sensing chip. The protective glass is disposed above the sensing chip, so that dust, sundries, or the like cannot fall on the sensing chip, so as to avoid impact on performance of the sensing chip.

In a possible implementation of the fourth aspect, the disposing the PCB on the substrate layer includes: bonding the PCB to the substrate layer through an adhesive; or soldering or riveting the PCB to the substrate layer.

In a possible implementation of the fourth aspect, the sensing chip is a die.

In a possible implementation of the fourth aspect, the sensing chip is a photosensitive chip.

It may be understood that, for beneficial effect that can be achieved by any one of the detection apparatus, the terminal, and the method for the integrated apparatus provided above, refer to beneficial effect of the integrated apparatus provided above. Details are not described herein again.

### BRIEF DESCRIPTION OF DRAWINGS

FIG. 1 is a diagram of an application scenario of a lidar according to an embodiment of this application;
FIG. 2 is a diagram of a structure of a lidar according to an embodiment of this application;
FIG. 3 is a diagram of a structure of another lidar according to an embodiment of this application;
FIG. 4 is a diagram of an arrangement manner of components in a receiving module;
FIG. 5 is a cross-sectional view of an integrated apparatus according to an embodiment of this application;
FIG. 6 is an exploded view of an integrated apparatus according to an embodiment of this application;
FIG. 7 is a cross-sectional view of another integrated apparatus according to an embodiment of this application;
FIG. 8 is a diagram of a structure of a substrate layer according to an embodiment of this application;
FIG. 9 is a cross-sectional view of another integrated circuit according to an embodiment of this application;
FIG. 10 is an exploded view of another integrated apparatus according to an embodiment of this application;
FIG. 11 is a schematic flowchart of a manufacturing method for an integrated apparatus according to an embodiment of this application;
FIG. 12 is a cross-sectional view of an integrated apparatus in a manufacturing process according to an embodiment of this application; and
FIG. 13 is a cross-sectional view of another integrated apparatus in a manufacturing process according to an embodiment of this application.

### DESCRIPTION OF EMBODIMENTS

The following clearly and completely describes the technical solutions in embodiments of this application with reference to the accompanying drawings in embodiments of this application.

A "connection" in embodiments of this application may be an electrical connection, and a connection between two electrical elements may be a direct or indirect connection between the two electrical elements. For example, that A is connected to B may be that A is directly connected to B, or may be that A is indirectly connected to B through one or more other electrical elements. For example, that A is connected to B may alternatively be that A is directly connected to C, C is directly connected to B, and A and B are connected through C. In some scenarios, the "connection" may alternatively be understood as coupling, for example, electromagnetic coupling between two inductors. In conclusion, the connection between A and B enables transmission of electric energy between A and B.

A terminal name of an electronic component in embodiments of this application is merely an example description, and may be understood as a connection end or a connection point, and is configured to connect to another circuit component. In another example, there may be another terminal name, a connection terminal name, or a connection point name. For example, in some scenarios, the terminal may also be referred to as a communication terminal, an information transmission terminal, a terminal, a connection terminal, a communication connection terminal, an information connection terminal, a connection point, a communication connection point, an information connection point, or an electrode.

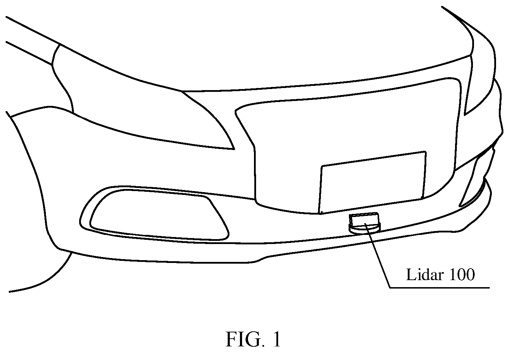

An embodiment of this application provides an integrated apparatus. In an application scenario, the integrated apparatus may be used in a detection apparatus, for example, a lidar. FIG. 1 is a diagram of an example of an application scenario of a lidar according to an embodiment of this application. In this example, a lidar 100 is mounted on a vehicle, and therefore is also referred to as a vehicle-mounted lidar. In addition to the vehicle-mounted lidar, the lidar further includes a shipborne lidar mounted on a ship, an airborne lidar mounted on a machine, or the like. In a possible example, as shown in FIG. 1, the lidar 100 may be mounted, for example, at a head location of a vehicle. In this way, in a driving process of the vehicle, the lidar 100 may send a laser signal. After being irradiated to an object in a surrounding environment, the laser signal is reflected by the object, and a reflected target echo signal may be received by the lidar 100, so that the lidar 100 obtains surrounding environment information of the vehicle through detection based on the target echo signal, to assist or control a driving function of the vehicle by using the environment information, for example, including but not limited to autonomous driving or assisted driving.

The lidar 100 may be one of a mechanical lidar, a liquid lidar, a pure solid-state lidar, or a hybrid solid-state lidar (also referred to as a semi-solid-state lidar), or may be another type of lidar. This is not specifically limited in embodiments of this application. In addition, a housing of the lidar 100 may be a cuboid shown in FIG. 1, or may be a cube, a cylinder, an annular body, an amorphous body, or the like. A shape of the housing of the detection apparatus is not specifically limited in embodiments of this application.

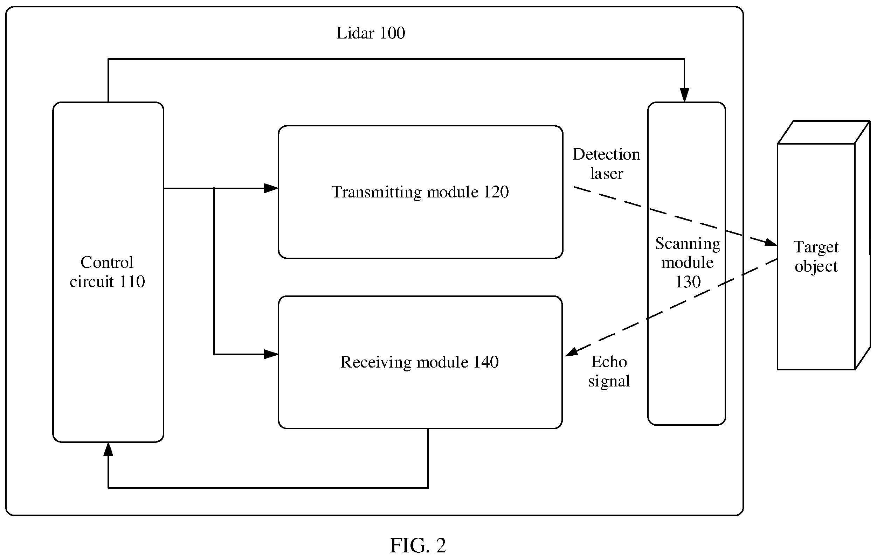

Further, FIG. 2 shows a diagram of an internal architecture of a lidar according to an embodiment of this application. As shown in FIG. 2, a lidar 100 may include a control circuit 110, a transmitting module 120, a scanning module 130, and a receiving module 140. The transmitting module 120 and the receiving module 140 include optical elements such as one or more of a lens, a light filter, a polarizer, a reflector, a beam splitter, a prism, a window plate, and a scattering sheet. A specific quantity and types of the included optical elements are related to optical designs of the transmitting module 120 and the receiving module 140 in the lidar 100. This is not specifically limited in embodiments of this application. The transmitting module 120 may include at least one optical laser, and the at least one optical laser may be connected in series or in parallel, and is configured to emit a detection laser under control of the control circuit 110. The scanning module 130 may include one or more of a multi-faceted rotating mirror, a swing mirror, a micro-electro-mechanical system (micro-electro-mechanical system, MEMS) scanning mirror, or a prism, and is configured to change, under control of the control circuit 110, a scanning angle of the detection laser emitted by the transmitting module 120, so that the detection laser can perform traverse scanning on a target object in an environment. For different types of lidars, implementations of the scanning module 130 are different, and there may alternatively be no scanning module in some types of lidars, for example, a phased-array radar in a solid-state lidar. The detection laser emitted by the transmitting module 120 is further reflected by the target object in the environment, to generate an echo signal. The receiving module 140 may be configured to: receive, under control of the control circuit 110, the echo signal corresponding to the detection laser, convert the echo signal into an electrical signal, and send the electrical signal to the control circuit 110. The control circuit 110 determines a feature of the target object based on the electrical signal.

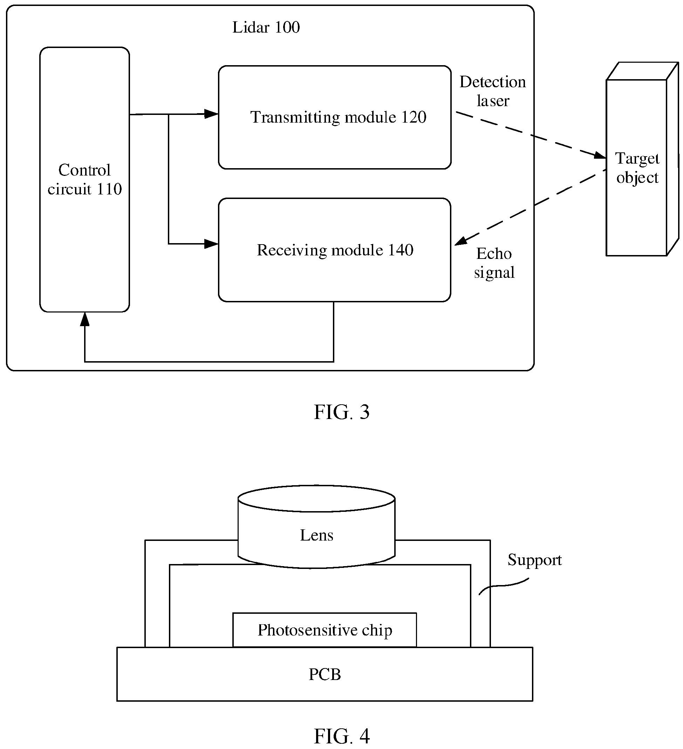

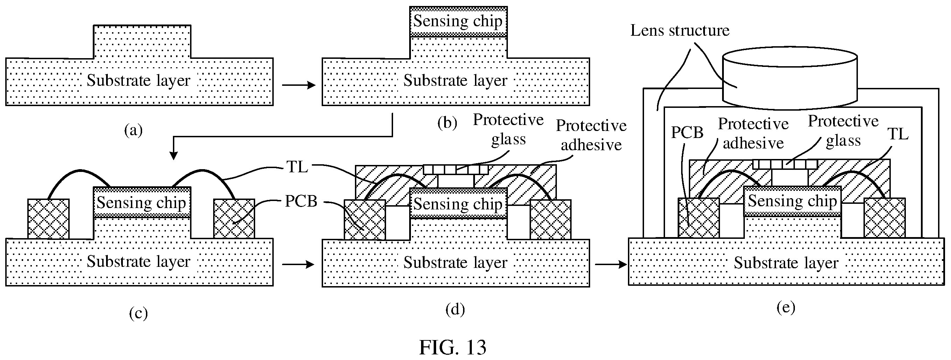

FIG. 3 shows a diagram of an internal architecture of another lidar according to an embodiment of this application. As shown in FIG. 3, a lidar 100 may include a control circuit 110, a transmitting module 120, and a receiving module 140. The transmitting module 120 and the receiving module 140 include optical elements such as one or more of a lens, a light filter, a polarizer, a reflector, a beam splitter, a prism, a window plate, and a scattering sheet. A specific quantity and type of the included optical elements are related to optical designs of the transmitting module 120 and the receiving module 140 in the lidar 100. This is not specifically limited in embodiments of this application. The transmitting module 120 may include at least one optical laser. The at least one optical laser may be connected in series or in parallel, and is configured to emit a detection laser under control of the control circuit 110. The transmitting module 120 is further configured to change a scanning angle of the detection laser under control of the control circuit 110, so that the detection laser can perform traverse scanning on a target object in an environment. The detection laser emitted by the transmitting module 120 is further reflected by the target object in the environment, to generate an echo signal. The receiving module 140 may be configured to receive, under control of the control circuit 110, the echo signal corresponding to the detection laser, and may be specifically configured to: receive an echo signal within a specific scanning angle, convert the echo signal into an electrical signal, and send the electrical signal to the control circuit 110. The control circuit 110 determines a feature of the target object based on the electrical signal.

It may be understood that, in actual application, the lidar 100 may include more or fewer components than those shown in FIG. 2 and FIG. 3. This is not specifically limited in embodiments of this application.

The control circuit 110 in FIG. 2 and FIG. 3 may include at least one integrated circuit chip. For example, the control circuit 110 may include at least one processor, and when the control circuit 110 includes a plurality of processors, types of the included processors may be the same or different. The processor is an element or circuit having a processing capability, for example, including one or more of the following types: a general-purpose processor, a field programmable gate array (field programmable gate array, FPGA), an application-specific integrated chip (application-specific integrated circuit, ASIC), a neural-network processing unit (neural-network processing unit, NPU), a graphics processing unit (graphics processing unit, GPU), an application processor (application processor, AP), a modem processor, an image signal processor (image signal processor, ISP), a video codec, a digital signal processor (digital signal processor, DSP), a baseband processor, a network processor (network processor, NP), a digital signal processing circuit (digital signal processor, DSP), a micro controller unit (micro controller unit, MCU), a programmable controller (programmable logic device, PLD) or another programmable logic device, a discrete gate or a transistor logic device, a discrete hardware component, or another integrated chip. The general-purpose processor includes, for example, a central processing unit (central processor unit, CPU). In addition, all or some integrated circuit chips included in the control circuit 110 may be integrated together and presented in a form of a system on chip (system on chip, SoC).

In a possible embodiment, the receiving module 140 may include a lens structure and a photosensitive chip. The lens structure may be configured to focus the received echo signal corresponding to the detection laser on a photosensitive surface of the optical-to-electrical conversion device. The photosensitive chip may be configured to convert the echo signal into an electrical signal. Optionally, the lens structure may include a lens and a support. The support may be configured to fasten the lens. The photosensitive chip may be a single photon avalanche diode (single photon avalanche diode, SPAD) chip.

Further, FIG. 4 is a diagram of an arrangement manner of the receiving module 140. In this arrangement manner, a printed circuit board (printed circuit board, PCB) is disposed. The photosensitive chip in the receiving module 140 is soldered on the PCB. The lens structure covers the photosensitive chip and is fastened to the PCB through an adhesive, a screw, or the like. The photosensitive chip is connected to the PCB through a transmission line. In addition, to protect the transmission line and the photosensitive chip, a protective adhesive may be coated on the transmission line between the photosensitive chip and the PCB, and protective glass is disposed above the photosensitive chip.

However, with continuous improvement of object recognition precision of the lidar and continuous iteration and update of a cable harness and an angular resolution of the lidar, requirements on signal processing speed performance of the receiving module and a target surface of the photosensitive chip are also continuously improved. Consequently, power consumption of the receiving module is multiplied. However, heat dissipation performance of the PCB is poor. In the foregoing arrangement manner, the photosensitive chip is soldered on the PCB, which is not conducive to heat dissipation of the photosensitive chip. In addition, under a same temperature difference, because a deformation amount of the PCB and a deformation amount of the lens structure are inconsistent with a deformation amount of the photosensitive chip, a chip stress and a decrease in a modulation transfer function (modulation transfer function, MTF) at a high or low temperature occur on the photosensitive chip. The MTF may also be referred to as a resolving power.

In view of this, an embodiment of this application provides an integrated apparatus. A substrate layer is disposed in the integrated apparatus, a sensing chip in the integrated apparatus is disposed on the substrate layer, and it is ensured that a difference between a coefficient of thermal expansion (coefficient of thermal expansion, CTE) of the substrate layer and a CTE of the sensing chip is small, so that the photosensitive chip quickly dissipates heat through the substrate layer, and under a same temperature difference, it is ensured that a deformation amount of the photosensitive chip is consistent with a deformation amount of the substrate layer, thereby resolving a problem of a chip stress.

The following describes, by using specific embodiments, specific implementation of the integrated apparatus provided in embodiments of this application.

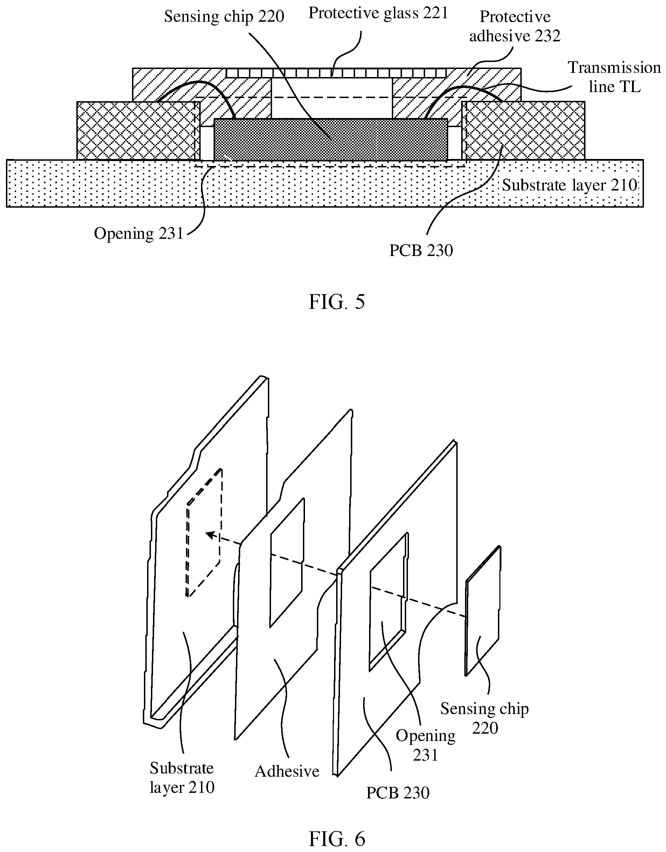

FIG. 5 and FIG. 6 each are a diagram of a structure of an integrated apparatus according to an embodiment of this application. FIG. 5 is a cross-sectional view of the integrated apparatus, and FIG. 6 is an exploded view of the integrated apparatus. The integrated apparatus includes a substrate layer 210, a sensing chip 220, and a PCB 230. The sensing chip 220 is disposed on the substrate layer 210. The PCB 230 is disposed on the substrate layer 210, the PCB 230 is provided with an opening 231, the sensing chip 220 is located in the opening 231, and the sensing chip 220 is connected to the PCB 230 through a transmission line TL. A difference between a CTE of the substrate layer 210 and a CTE of the sensing chip 220 is less than a first preset threshold.

The substrate layer 210 may include a material with good heat dissipation performance. For example, the substrate layer 210 may include a metal material and/or a ceramic material. The metal material may be a metal monomer, or may include a metal compound or an alloy material, or may include a combination of the foregoing materials.

In addition, the sensing chip 220 may be a chip integrated with a sensor (sensor). Optionally, the sensing chip 220 may be a die (die), and the die may also be referred to as a die or a bare die. The die or the bare die may be a small block obtained by cutting from a wafer (wafer). The wafer may also be referred to as a wafer, and is a silicon wafer used for manufacturing a silicon semiconductor circuit. An original material of the wafer may be silicon.

Optionally, the sensing chip 220 is disposed on the substrate layer 210, and this may be implemented in any one of the following manners. In a first manner, the sensing chip 220 is bonded to the substrate layer 210 through an adhesive. For example, the adhesive may be a glass adhesive, a single-component adhesive, or a multi-component adhesive. In a second manner, the sensing chip 220 is soldered to the substrate layer 210. For example, the sensing chip is provided with a solder ball, and the sensing chip 220 is soldered to the substrate layer 210 through the solder ball. In a third manner, the sensing chip 220 is riveted to the substrate layer 210. For example, the sensing chip 220 is fastened to the substrate layer 210 through a rivet. During actual application, a person skilled in the art may alternatively dispose the sensing chip 220 on the substrate layer 210 in another manner. The foregoing examples do not constitute a limitation on embodiments of this application.

Similarly, the PCB 230 may also be disposed on the substrate layer 210 in a similar manner. For example, the PCB 230 may be bonded to the substrate layer 210 through an adhesive like a glass adhesive, a single-component adhesive, or a multi-component adhesive; or the PCB 230 may be soldered to the substrate layer 210 through a solder ball or the like; or the PCB 230 may be riveted to the substrate layer 210 through a rivet or the like. In FIG. 6, an example in which the PCB 230 is connected to the substrate layer 210 through an adhesive is used for description. During actual application, a person skilled in the art may alternatively dispose the PCB 230 on the substrate layer 210 in another manner. The foregoing examples do not constitute a limitation on embodiments of this application.

In addition, the transmission line TL configured to connect the sensing chip 220 to the PCB 230 may be a metal wire. For example, the metal may be aurum (Au), that is, the transmission line TL is a gold wire. The sensing chip 220 is connected to the PCB 230 through the gold wire, so that attenuation of the transmission line TL on a transmission signal can be reduced.

Optionally, there is a height difference between the sensing chip 220 and the PCB 230. For example, a height of the sensing chip 220 is greater than a height of the PCB 230; or a height of the sensing chip 220 is less than a height of the PCB 230. In FIG. 5, an example in which the height of the sensing chip 220 is less than the height of the PCB 230 is used for description. When there is the height difference between the sensing chip 220 and the PCB 230, it is helpful to form the transmission line TL between the sensing chip 220 and the PCB 230 when the integrated apparatus is manufactured.

That a difference between a CTE of the substrate layer 210 and a CTE of the sensing chip 220 is less than a first preset threshold may include: A difference obtained by subtracting the CTE of the sensing chip 220 from the CTE of the substrate layer 210 is less than the first preset threshold, or a difference obtained by subtracting the CTE of the substrate layer 210 from the CTE of the sensing chip 220 is less than the first preset threshold. That is, the difference between the CTE of the substrate layer 210 and the CTE of the sensing chip 220 is small. Optionally, the first preset threshold is greater than or equal to 0 ppm/°C and less than or equal to 10 ppm/°C. In an example, the CTE of the sensing chip 220 may be about 2 ppm/°C, and the CTE of the substrate layer 210 may be greater than or equal to 3 ppm/°C and less than or equal to 12 ppm/°C.

In the integrated apparatus provided in embodiments of this application, the sensing chip 220 and the PCB 230 are disposed on the substrate layer 210, the sensing chip 220 is located in the opening 231 on the PCB 230, the sensing chip 220 is connected to the PCB 230 through the transmission line TL, and the difference between the CTE of the substrate layer 210 and the CTE of the sensing chip 220 is less than the first preset threshold. In this way, the sensing chip 220 can rapidly dissipate heat by using the substrate layer 210, and under a same temperature difference, it can be ensured that a deformation amount of the substrate layer 210 is basically consistent with a deformation amount of the sensing chip 220, thereby resolving a problem of a chip stress of the sensing chip 220.

In a possible embodiment, the substrate layer 210 includes at least one of the following materials: aluminum silicon carbide AlSiC, aluminum Al, copper Cu, and wolfram W. In an example, a material included in the substrate layer 210 is aluminum silicon carbide AlSiC. In another example, a material included in the substrate layer 210 is aluminum Al, copper Cu, or wolfram W. In still another example, materials included in the substrate layer 210 are aluminum silicon carbide AlSiC and aluminum Al, or aluminum silicon carbide AlSiC and copper Cu, or aluminum silicon carbide AlSiC and wolfram W.

When the substrate layer 210 includes aluminum silicon carbide AlSiC, the CTE of the substrate layer 210 may be adjusted by adjusting content of Al in aluminum silicon carbide AlSiC. When the substrate layer 210 includes at least two materials, the CTE of the substrate layer 210 may be adjusted by adjusting content of the at least two materials.

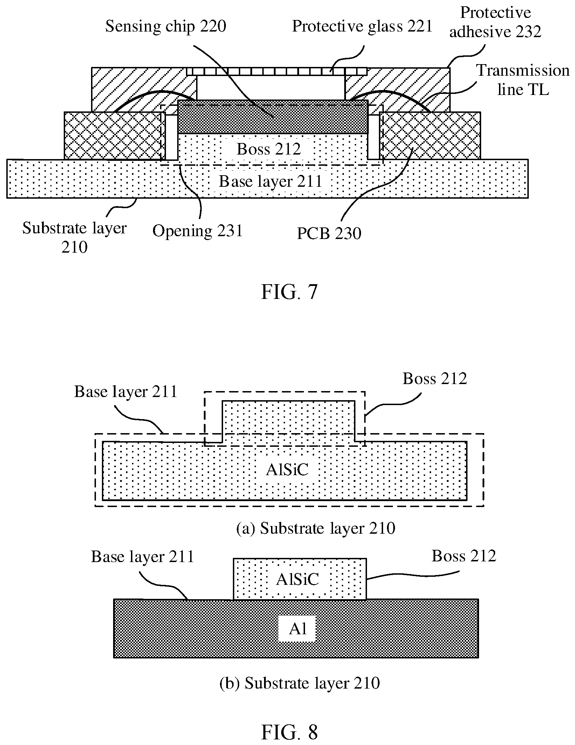

Further, as shown in FIG. 7, the substrate layer 210 includes a base layer 211 and a boss 212 disposed on the base layer 211, and the sensing chip 220 is disposed on the boss 212.

When the sensing chip 220 is disposed on the boss 212, the boss 212 may also be located in the opening 231 on the PCB 230, that is, both the boss 212 and the sensing chip 220 are located in the opening 231 on the PCB 230. The sensing chip 220 may further pass through the opening 231 on the PCB 230 to form a height difference between the sensing chip 220 and the PCB 230, that is, in this case, the height of the sensing chip 220 may be greater than the height of the PCB 230.

Optionally, as shown in (a) in FIG. 8, the base layer 211 and the boss 212 are integrally formed. In other words, the base layer 211 and the boss 212 may be two parts of a same substrate layer that are formed in one process. Alternatively, as shown in (b) in FIG. 8, the base layer 211 and the boss 212 are not integrally formed, but are two parts that are independently disposed. For example, the base layer 211 and the boss 212 may be formed in two independent processes. When the base layer 211 and the boss 212 are two independently disposed parts, the boss 212 may be bonded to the base layer 211 through an adhesive, or may be soldered to the base layer 211 through a solder ball or riveted to the base layer 211 through a rivet.

Optionally, a material of the base layer 211 is the same as or different from a material of the boss 212. In a possible example, the material of the base layer 211 is the same as the material of the boss 212. For example, both the material of the base layer 211 and the material of the boss 212 are aluminum silicon carbide AlSiC, copper Cu, aluminum Al, or wolfram W. In another possible example, the material of the base layer 211 is different from the material of the boss 212. For example, the material of the base layer 211 is aluminum Al, copper Cu, or wolfram W, and the material of the boss 212 is aluminum silicon carbide AlSiC. In (a) in FIG. 8, an example in which the material of the base layer 211 and the material of the boss 212 are the same and both are aluminum silicon carbide AlSiC is used for description. In (b) in FIG. 8, an example in which the material of the base layer 211 is different from the material of the boss 212, the material of the base layer 211 is aluminum Al, and the material of the boss 212 is aluminum silicon carbide AlSiC is used for description.

Further, as shown in FIG. 5 and FIG. 7, the integrated apparatus may further include a protective adhesive 232 configured to protect the transmission line TL. That is, when the integrated circuit is manufactured, the transmission line TL may be further coated with the protective adhesive 232, to avoid interference caused by a peripheral component of the transmission line TL to a transmission signal on the transmission line TL. Optionally, the protective adhesive 232 may be a glass adhesive.

In addition, as shown in FIG. 5 and FIG. 7, the integrated apparatus further includes protective glass 221, and the protective glass 221 is located above the sensing chip 220. In an example, the protective glass 221 may be fastened above the sensing chip 220 through the protective adhesive 232. The protective glass 221 is disposed above the sensing chip 220, so that dust, sundries, or the like cannot fall on the sensing chip 220, to avoid impact on performance of the sensing chip 220.

In a possible embodiment, the sensing chip 220 is a photosensitive chip, and the photosensitive chip may be a chip that can convert an optical signal into an electrical signal. In an example, the photosensitive chip is specifically a SPAD chip. In this way, when the integrated apparatus is used in a receiving module of a lidar, heat dissipation performance of the photosensitive chip in the receiving module can be improved, and a problem of a chip stress occurring on the sensing chip 220 due to inconsistency between the CTE of the sensing chip 220 and the CTE of the PCB 230 is avoided.

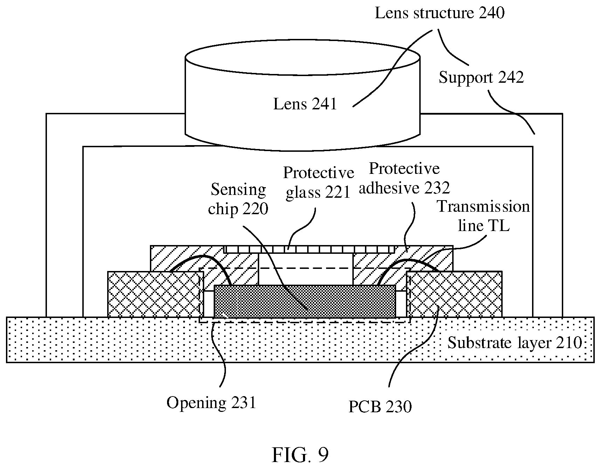

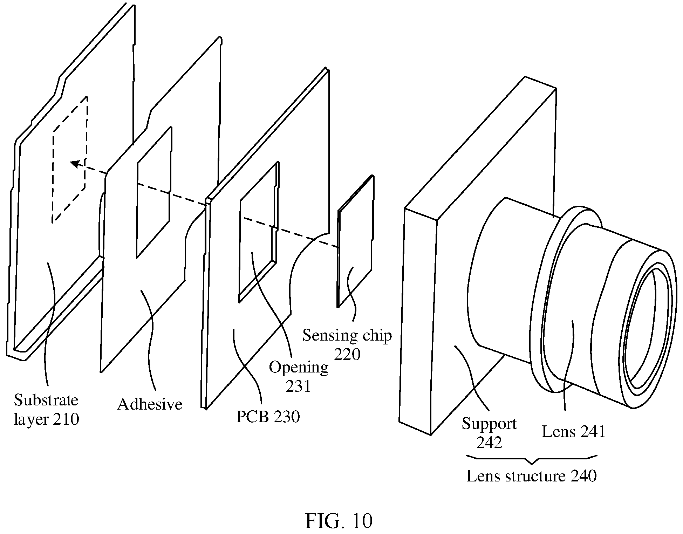

Further, as shown in FIG. 9 and FIG. 10, the integrated apparatus may further include a lens structure 240. The lens structure 240 covers the sensing chip 220 and is fastened to the substrate layer 210. A focus of the lens structure 240 is located on a photosensitive surface of the sensing chip 220. FIG. 9 shows a cross-sectional view of the integrated apparatus, and FIG. 9 shows an exploded view of the integrated apparatus. In FIG. 9 and FIG. 10, an example in which the substrate layer 210 in the integrated apparatus does not include the boss 212 is used for description, and in FIG. 10, an example in which the PCB 230 is connected to the substrate layer 210 through an adhesive is used for description.

The lens structure 240 may include a lens 241 and a support 242, the support 242 may be configured to fasten the lens 241, and the lens structure 240 may be fastened to the substrate layer 210 by using the support 242.

Optionally, that the lens structure 240 is fastened to the substrate layer 210 may specifically include: The lens structure 240 is bonded to the substrate layer 210; or the lens structure 240 is soldered to the substrate layer 210; or the lens structure 240 is riveted to the substrate layer 210. In this embodiment of this application, the foregoing fastening manners are merely used as examples for description, and do not constitute a limitation on embodiments of this application.

In a possible embodiment, a difference between a CTE of the lens structure 240 and the CTE of the sensing chip 220 is less than a second preset threshold. That the difference is less than the second preset threshold may include: A difference obtained by subtracting the CTE of the sensing chip 220 from the CTE of the lens structure 240 is less than the second preset threshold, or a difference obtained by subtracting the CTE of the lens structure 240 from the CTE of the sensing chip 220 is less than the second preset threshold. That is, the difference between the CTE of the lens structure 240 and the CTE of the sensing chip 220 is small. Optionally, the second preset threshold is greater than or equal to 0 ppm/°C and less than or equal to 10 ppm/°C.

In this embodiment of this application, the difference between the CTE of the lens structure 240 and the CTE of the sensing chip 220 is set to be less than the second preset threshold, so that the CTE of the lens structure 240 and the CTE of the sensing chip 220 can compensate for each other. In this way, under a same temperature difference, a deformation amount of the lens structure 240 is basically consistent with a deformation amount of the sensing chip 220, thereby ensuring that the focus of the lens structure 240 is always located on the photosensitive surface of the sensing chip 220. This avoids a decrease in an MTF of the sensing chip 220 at a high temperature and a low temperature due to inconsistency between the deformation amount of the lens structure 240 and the deformation amount of the sensing chip 220.

In view this, an embodiment of this application further provides a detection apparatus. The detection apparatus includes a control circuit and a receiving module. The receiving module includes any one of the integrated apparatuses provided above. The control circuit is configured to send a first control signal to the receiving module. The receiving module is configured to: receive, based on the first control signal, an echo signal returned after a detection laser scans a target object, and convert the echo signal into an electrical signal. The control circuit is further configured to process the electrical signal to obtain point cloud data. Optionally, the detection apparatus further includes a transmitting module, the control circuit is further configured to send a second control signal to the transmitting module, and the transmitting module is configured to emit the detection laser based on the second control signal.

In a possible embodiment, the detection apparatus further includes a scanning module, and the scanning module may be configured to change, under control of the control circuit, a receiving angle at which the receiving module receives the echo signal. Optionally, the scanning module may be configured to change, under control of the control circuit, a scanning angle of the detection laser emitted by the transmitting module.

Optionally, the detection apparatus may be a lidar, or another apparatus that can emit a detection laser. For example, some examples of the detection apparatus include but are not limited to: a vehicle-mounted lidar, a laser sensor of a home robotic vacuum cleaner, a laser detection module at a dock, a laser printer, and the like.

An embodiment of this application further provides a terminal, including the detection apparatus described in the foregoing content. Optionally, the terminal includes but is not limited to: a smart home device (for example, a television, a robotic vacuum cleaner, a smart desk lamp, an acoustic system, an intelligent lighting system, an electrical control system, home background music, a home theater system, an intercom system, and a video surveillance), an intelligent transportation device (for example, a vehicle, a ship, an uncrewed aerial vehicle, a train, a lorry, or a truck), an intelligent manufacturing device (for example, a robot, an industrial device, intelligent logistics, or a smart factory), or an intelligent terminal (a mobile phone, a computer, a tablet computer, a palmtop computer, a desktop computer, a headset, a speaker, a wearable device, an in-vehicle device, a virtual reality device, an augmented reality device, and the like).

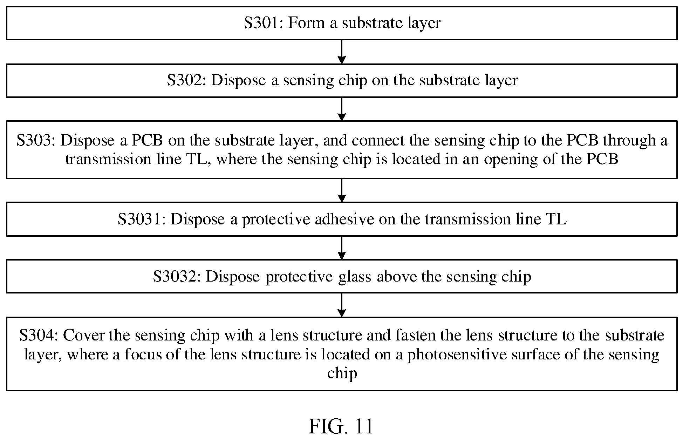

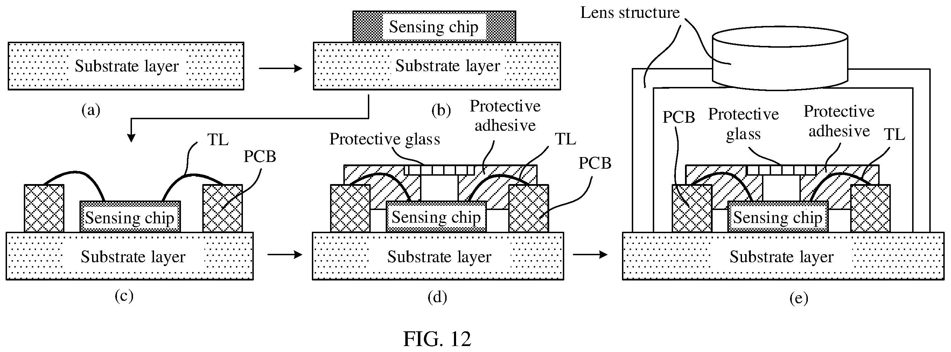

FIG. 11 is a schematic flowchart of a manufacturing method for an integrated apparatus according to an embodiment of this application. The integrated apparatus may be the integrated apparatus provided above. The method includes the following several steps. FIG. 12 and FIG. 13 are cross-sectional views of the integrated apparatus in a manufacturing process.

S301: Form a substrate layer. This is shown in (a) in FIG. 12 or (a) in FIG. 13.

The substrate layer may include a material with good heat dissipation performance. For example, the substrate layer may include a metal material and/or a ceramic material. The metal material may be a metal monomer, or may include a metal compound or an alloy material, or may include a combination of the foregoing materials.

In a possible embodiment, the substrate layer includes at least one of the following materials: aluminum silicon carbide AlSiC, aluminum Al, copper Cu, and wolfram W. In an example, a material included in the substrate layer is aluminum silicon carbide AlSiC. In another example, a material included in the substrate layer is aluminum Al, copper Cu, or wolfram W. In still another example, materials included in the substrate layer are aluminum silicon carbide AlSiC and aluminum Al, or aluminum silicon carbide AlSiC and copper Cu, or aluminum silicon carbide AlSiC and wolfram W.

Optionally, the substrate layer includes a base layer and a boss. In a possible embodiment, the base layer and the boss are integrally formed. In other words, the base layer and the boss may be two parts of a same substrate layer that are formed in one process. Alternatively, the base layer and the boss are not integrally formed, but are two parts that are independently disposed. For example, the base layer and the boss may be formed in two independent processes. When the base layer and the boss are two independently disposed parts, the boss may be bonded to the base layer through an adhesive, or may be riveted to the base layer through a rivet or the like. In FIG. 12, an example in which the substrate layer does not include the boss is used for description, and in FIG. 13, an example in which the substrate layer includes the boss is used for description.

Optionally, a material of the base layer is different from a material of the boss. In a possible example, the material of the base layer is the same as the material of the boss. For example, both the material of the base layer and the material of the boss are aluminum silicon carbide AlSiC, aluminum Al, copper Cu, or wolfram W. In another possible example, the material of the base layer is different from the material of the boss. For example, the material of the base layer is aluminum Al, copper Cu, or wolfram W, and the material of the boss is aluminum silicon carbide AlSiC.

When the substrate layer includes aluminum silicon carbide AlSiC, a CTE of the substrate layer may be adjusted by adjusting content of Al in aluminum silicon carbide AlSiC. When the substrate layer includes at least two materials, the CTE of the substrate layer may be adjusted by adjusting content of the at least two materials.

S302: Dispose a sensing chip on the substrate layer. This is shown in (b) in FIG. 12 or (b) in FIG. 13.

The sensing chip may be a chip integrated with a sensor. In a possible embodiment, the sensing chip may be a die, and the die may also be referred to as a die or a bare die. The die or the bare die may be a small block obtained by cutting from a wafer. The wafer may also be referred to as a wafer, and is a silicon wafer used for manufacturing a silicon semiconductor circuit. An original material of the wafer may be silicon.

Optionally, a difference between a CTE of the substrate layer and a CTE of the sensing chip is less than a first preset threshold, that is, a difference obtained by subtracting the CTE of the sensing chip from the CTE of the substrate layer is less than the first preset threshold, or a difference obtained by subtracting the CTE of the substrate layer from the CTE of the sensing chip is less than the first preset threshold. Optionally, the first preset threshold is greater than or equal to 0 ppm/°C and less than or equal to 10 ppm/°C. In an example, the CTE of the sensing chip may be about 2 ppm/°C, and the CTE of the substrate layer 210 may be greater than or equal to 3 ppm/°C and less than or equal to 12 ppm/°C.

Specifically, the sensing chip is disposed on the substrate layer, and this may be implemented in any one of the following manners. In a first manner, the sensing chip is bonded to the substrate layer through an adhesive. For example, the adhesive may be a glass adhesive, a single-component adhesive, or a multi-component adhesive. In a second manner, the sensing chip is soldered to the substrate layer. For example, the sensing chip is provided with a solder ball, and the sensing chip is soldered to the substrate layer through the solder ball. In a third manner, the sensing chip is riveted to the substrate layer. For example, the sensing chip is fastened to the substrate layer through a rivet.

S303: Dispose a PCB on the substrate layer, and connect the sensing chip to the PCB through a transmission line TL, where the sensing chip is located in an opening of the PCB. This is shown in (c) in FIG. 12 or (c) in FIG. 13.

Specifically, the disposing a PCB on the substrate layer may include: bonding the PCB to the substrate layer through an adhesive; or soldering the PCB to the substrate layer through a solder ball of the PCB; or riveting the PCB to the substrate layer through a rivet.

The transmission line TL configured to connect the sensing chip to the PCB may be a metal wire. For example, the metal may be aurum (Au), that is, the transmission line TL is a gold wire. The sensing chip is connected to the PCB through the gold wire, so that attenuation of the transmission line TL on a transmission signal can be reduced.

Optionally, there is a height difference between the sensing chip and the PCB. For example, as shown in (c) in FIG. 12, a height of the sensing chip is less than a height of the PCB; or as shown in (c) in FIG. 13, a height of the sensing chip is greater than a height of the PCB. The height difference formed between the sensing chip and the PCB helps to form the transmission line TL between the sensing chip and the PCB.

In a possible embodiment, the integrated apparatus further includes a protective adhesive, and the method may further include the following step. S3031: Dispose the protective adhesive on the transmission line TL. This is shown in (d) in FIG. 12 or (d) in FIG. 13. Specifically, the transmission line TL is coated with the protective adhesive, to avoid interference caused by a peripheral component of the transmission line TL to a transmission signal on the transmission line TL. Optionally, the protective adhesive may be a glass adhesive.

In another possible embodiment, the integrated apparatus further includes protective glass, and the method may further include the following step. S3032: Dispose the protective glass above the sensing chip. This is shown in (d) in FIG. 12 or (d) in FIG. 13. In an example, the protective glass may be fastened above the sensing chip through the glass adhesive. The protective glass is disposed above the sensing chip, so that dust, sundries, or the like cannot fall on the sensing chip, to avoid impact on performance of the sensing chip.

In this embodiment of this application, the sensing chip and the PCB are disposed on the substrate layer, the sensing chip is located in the opening on the PCB, the sensing chip is connected to the PCB through the transmission line TL, and the difference between the CTE of the substrate layer and the CTE of the sensing chip is less than the first preset threshold. In this way, the sensing chip can rapidly dissipate heat by using the substrate layer, and under a same temperature difference, it can be ensured that a deformation amount of the substrate layer is basically consistent with a deformation amount of the sensing chip, thereby resolving a problem of a chip stress of the sensing chip.

Further, the integrated apparatus further includes a lens structure. Correspondingly, as shown in FIG. 11, the method may further include S304.

S304: Cover the sensing chip with the lens structure and fasten the lens structure to the substrate layer, where a focus of the lens structure is located on a photosensitive surface of the sensing chip. This is shown in (e) in FIG. 12 or (e) in FIG. 13.

The lens structure may include a lens and a support, the support may be configured to fasten the lens, and the lens structure may be fastened to the substrate layer by using the support. Optionally, that the lens structure is fastened to the substrate layer may specifically include: The lens structure is bonded to the substrate layer; or the lens structure is soldered to the substrate layer; or the lens structure is riveted to the substrate layer. In (e) in FIG. 12 and (e) in FIG. 13, only an example in which the lens structure is riveted to the substrate layer is used for description.

In a possible embodiment, a difference between a CTE of the lens structure and the CTE of the sensing chip is less than a second preset threshold. That the difference is less than the second preset threshold may include: A difference obtained by subtracting the CTE of the sensing chip from the CTE of the lens structure is less than the second preset threshold, or a difference obtained by subtracting the CTE of the lens structure from the CTE of the sensing chip is less than the second preset threshold. That is, the difference between the CTE of the lens structure and the CTE of the sensing chip is small. Optionally, the second preset threshold is greater than or equal to 0 ppm/°C and less than or equal to 10 ppm/°C.

In this embodiment of this application, the difference between the CTE of the lens structure and the CTE of the sensing chip is set to be less than the second preset threshold, so that under a same temperature difference, a deformation amount of the lens structure is basically consistent with a deformation amount of the sensing chip, thereby ensuring that the focus of the lens structure is always located on the photosensitive surface of the sensing chip. This avoids a decrease in an MTF of the sensing chip at a high temperature and a low temperature due to inconsistency between the deformation amount of the lens structure and the deformation amount of the sensing chip.

Based on the manufacturing method provided in embodiments of this application, an embodiment of this application further provides a computer-readable storage medium. The computer-readable storage medium stores a computer program. When the computer program is run, the manufacturing method described in the foregoing content is performed.

Based on the manufacturing method provided in embodiments of this application, an embodiment of this application further provides a computer program product. When the computer program product runs on a processor, the manufacturing method described in the foregoing content is implemented.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An integrated apparatus, wherein the integrated apparatus comprises a substrate layer, a sensing chip, and a printed circuit board PCB, wherein
the sensing chip is disposed on the substrate layer;
the PCB is disposed on the substrate layer, the PCB is provided with an opening, the sensing chip is located in the opening, and the sensing chip is connected to the PCB through a transmission line; and
a difference between a coefficient of thermal expansion CTE of the substrate layer and a CTE of the sensing chip is less than a first preset threshold.

2. The integrated apparatus according to claim 1, wherein the substrate layer comprises a base layer and a boss, and the sensing chip is disposed on the boss.

3. The integrated apparatus according to claim 2, wherein the base layer and the boss are integrally formed; or a material of the base layer is different from a material of the boss.

4. The integrated apparatus according to any one of claims 1 to 3, wherein the sensing chip is bonded to the substrate layer through an adhesive; or the sensing chip is soldered or riveted to the substrate layer.

5. The integrated apparatus according to any one of claims 1 to 4, wherein the first preset threshold is greater than or equal to 0 ppm/°C and less than or equal to 10 ppm/°C.

6. The integrated apparatus according to any one of claims 1 to 5, wherein the substrate layer comprises at least one of the following materials: aluminum silicon carbide AlSiC, aluminum Al, copper Cu, and wolfram W.

7. The integrated apparatus according to any one of claims 1 to 6, wherein there is a height difference between the sensing chip and the PCB.

8. The integrated apparatus according to any one of claims 1 to 7, wherein the integrated apparatus further comprises:
a lens structure that covers the sensing chip and is fastened to the substrate layer, wherein a focus of the lens structure is located on a photosensitive surface of the sensing chip.

9. The integrated apparatus according to claim 8, wherein a difference between a CTE of the lens structure and the CTE of the sensing chip is less than a second preset threshold.

10. The integrated apparatus according to any one of claims 1 to 9, wherein the integrated apparatus further comprises a protective adhesive for protecting the transmission line.

11. The integrated apparatus according to any one of claims 1 to 10, wherein the integrated apparatus further comprises protective glass, and the protective glass is located above the sensing chip.

12. The integrated apparatus according to any one of claims 1 to 11, wherein the PCB is bonded to the substrate layer through an adhesive; or the PCB is soldered or riveted to the substrate layer.

13. The integrated apparatus according to any one of claims 1 to 12, wherein the sensing chip is a die.

14. The integrated apparatus according to claim 13, wherein the sensing chip is a photosensitive chip.

15. A detection apparatus, wherein the detection apparatus comprises a control circuit and the integrated apparatus according to any one of claims 1 to 14, and the control circuit is configured to receive a signal output by the integrated apparatus.

16. A terminal, wherein the terminal comprises the detection apparatus according to claim 15.

17. The terminal according to claim 16, wherein the terminal is a vehicle.

18. A manufacturing method for an integrated apparatus, wherein the integrated apparatus comprises a substrate layer, a sensing chip, and a printed circuit board PCB having an opening, and the method comprises:
forming the substrate layer;
disposing the sensing chip on the substrate layer; and
disposing the PCB on the substrate layer, and connecting the sensing chip to the PCB through a transmission line, wherein the sensing chip is located in the opening of the PCB; and
a difference between a coefficient of thermal expansion CTE of the substrate layer and a CTE of the sensing chip is less than a first preset threshold.

19. The method according to claim 18, wherein the substrate layer comprises a base layer and a boss, and the sensing chip is disposed on the boss.

20. The method according to claim 19, wherein the base layer and the boss are integrally formed; or a material of the base layer is different from a material of the boss.

21. The method according to any one of claims 18 to 20, wherein the disposing the sensing chip on the substrate layer comprises:
bonding the sensing chip to the substrate layer through an adhesive; or soldering or riveting the sensing chip to the substrate layer.

22. The method according to any one of claims 18 to 21, wherein the first preset threshold is greater than or equal to 0 ppm/°C and less than or equal to 10 ppm/°C.

23. The method according to any one of claims 18 to 22, wherein the substrate layer comprises at least one of the following materials: aluminum silicon carbide AlSiC, aluminum Al, copper Cu, and wolfram W.

24. The method according to any one of claims 18 to 23, wherein there is a height difference between the sensing chip and the PCB.

25. The method according to any one of claims 18 to 24, wherein the integrated apparatus further comprises a lens structure, and the method further comprises:
covering the sensing chip with the lens structure and fastening the lens structure to the substrate layer, wherein a focus of the lens structure is located on a photosensitive surface of the sensing chip.

26. The method according to claim 25, wherein a difference between a CTE of the lens structure and the CTE of the sensing chip is less than a second preset threshold.

27. The method according to any one of claims 18 to 26, wherein the integrated apparatus further comprises a protective adhesive, and the method further comprises: disposing the protective adhesive on the transmission line.

28. The method according to any one of claims 18 to 27, wherein the integrated apparatus further comprises protective glass, and the method further comprises: disposing the protective glass above the sensing chip.

29. The method according to any one of claims 18 to 28, wherein the disposing the PCB on the substrate layer comprises: bonding the PCB to the substrate layer through an adhesive; or soldering or riveting the PCB to the substrate layer.

30. The method according to any one of claims 18 to 29, wherein the sensing chip is a die.

31. The method according to claim 30, wherein the sensing chip is a photosensitive chip.
